**Europäisches Patentamt**

**European Patent Office**

**Office européen des brevets**

(19)

(11) Veröffentlichungsnummer: **0 045 399**
**B1**

## EUROPÄISCHE PATENTSCHRIFT

(12)

(45) Veröffentlichungstag der Patentschrift:
**29.01.86**

(21) Anmeldenummer: **81105402.2**

(22) Anmeldetag: **10.07.81**

(51) Int. Cl.⁴: **G 11 C 11/24**

(54) **Monolithisch integrierter Halbleiterspeicher.**

(30) Priorität: **31.07.80 DE 3029108**

(43) Veröffentlichungstag der Anmeldung:
**10.02.82 Patentblatt 82/6**

(45) Bekanntmachung des Hinweises auf die Patenterteilung:
**29.01.86 Patentblatt 86/5**

(84) Benannte Vertragsstaaten:
**DE FR GB**

(56) Entgegenhaltungen:
**PATENTS ABSTRACTS OF JAPAN, Band 3, Nr.
124(E-144), 17. Oktober 1979, Seite 25E144
IBM TECHNICAL DISCLOSURE BULLETIN, Band 20, Nr.
8, Januar 1978, Seiten 3011-3013, New York, USA H.S.
LEE: "Converter for CCD multilevel shift registers"
IEEE INTERNATIONAL SOLID STATE CIRCUITS
CONFERENCE, Band 18, 13. Februar 1975, Seiten
102-103, New York, USA R. FOSS et al.: "Simplified
peripheral circuits for a marginally testable 4K RAM"
IBM TECHNICAL DISCLOSURE BULLETIN, Band 24, Nr.
1B, Juni 1981, Seiten 473-474, New York, USA W. WANG:
"Improved dummy cell for a random-access memory"**

(73) Patentinhaber: **Siemens Aktiengesellschaft, Berlin und
München Wittelsbacherplatz 2, D-8000 München 2 (DE)**

(72) Erfinder: **Kantz, Dieter, Dipl-Ing, Heighlhofstrasse 47,
D-8000 München 70 (DE)**
Erfinder: **Seher, Eugen, Ing.-Grad., Sindelfingerweg 9,,
D-7031 Grafenau 1 (DE)**

ACTORUM AG

**Beschreibung**

Die Erfindung bezieht sich auf einen monolithisch integrierten Halbleiterspeicher nach dem Oberbegriff des Patentanspruches 1.

Halbleiterspeicher dieser Art sind z.B. in «1979 IEEE International Solid-State Circuits Conference», Seite 140/141 bzw. S. 12/13, beschrieben.

Bei der üblichen Organisation solcher Halbleiterspeicher ist jeder Spalte der Speichermatrix je ein als Differenzverstärker wirksamer Komparator zugeteilt, der sich in der Mitte der betreffenden Spalte befindet und durch eine bistabile Kippstufe gegeben ist. Die eine Hälfte der insgesamt pro Spalte vorgesehenen Informations-Ein-Transistor-Speicherzellen ist mit dem Drainanschluss an den einen Eingang des Differenzverstärkers und die übrigen Speicherzellen der betreffenden Matrixspalte in derselben Weise an den anderen Eingang des Differenzverstärkers geschaltet. Weiterhin sind jeder Spalte zwei Vergleichszellen zugeordnet, die in gleicher Weise wie die Informations-Speicherzellen an je einen Eingang des Differenzverstärkers gelegt sind.

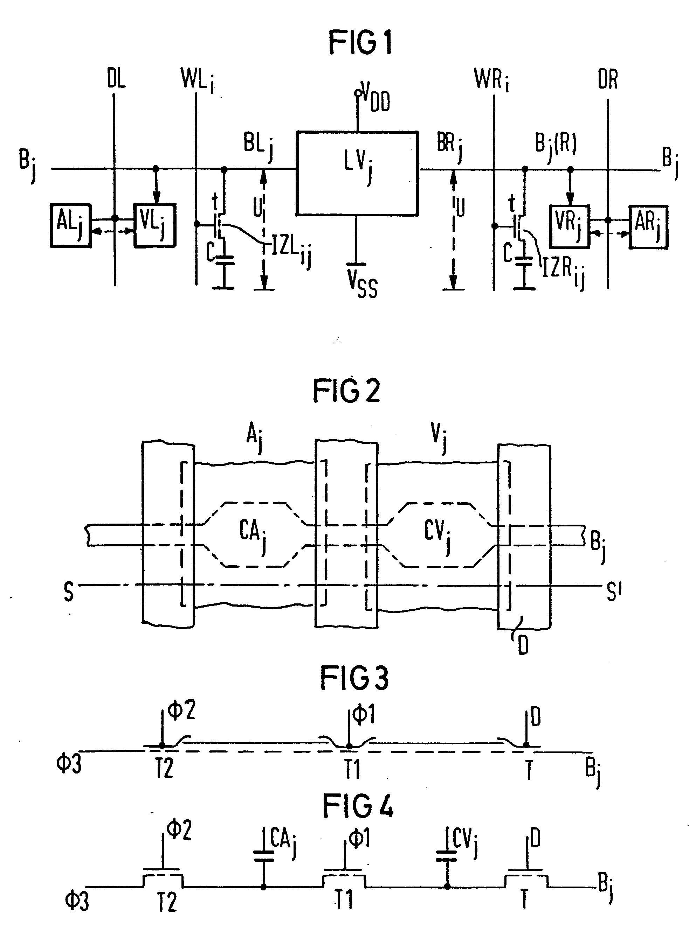

Im einzelnen hat man dann das aus Fig. 1 ersichtliche Schaltungsbild bei den einzelnen Spalten der Speichermatrix.

Verwendet man, wie üblich, für die den einzelnen Matrixzeilen zugeordneten und mit den Gateelektroden sämtlicher Speicherzellen der betreffenden Matrixzeile verbundenen Leitungen die Bezeichnung «Wortleitung» und für die den einzelnen Matrixspalten zugeordneten Leitungen die Bezeichnung «Bitleitung», so ist bei den üblichen Speichern dieser Art jede Bitleitung halbiert und die eine Hälfte an den einen Eingang des Differenz-Leseverstärkers, also des Komparators, und die andere Hälfte an den anderen Eingang dieses Verstärkers gelegt. Die pro Spalte vorgesehene Anzahl von Speicherzellen ist dementsprechend halbiert und je die halbe Anzahl der der betreffenden Spalte zugeordneten Speicherzellen an je eine Hälfte der betreffenden Bitleitung $B_j$ (j = Index) angeschlossen.

Der Komparator, also der Leseverstärker, hat die Aufgabe, zu unterscheiden, ob in einer durch Adressierung über die zugehörige Wortleitung an ihn angelegten Speicherzelle entweder der Zustand «0» oder der Zustand «1» eingespeichert ist, was sowohl für den Auslesevorgang bei der Auswertung als auch bei der Auffrischung der jeweils gespeicherten Information erforderlich ist. Um den Vergleich zu ermöglichen, wird die Vergleichszelle jeweils an den anderen Eingang des Komparators gelegt, der dann einen zwischen den beiden logischen Pegeln «0» und «1» liegenden mittleren Spannungspegel erhalten muss.

Hierzu ist es erforderlich, dass die resultierende Speicherkapazität in der Vergleichszelle den halben Wert der Speicherkapazität der einzelnen Informationsspeicherzellen aufweist. Man kann dann auf einfache Weise über die jeweiligen Bitleitungshälften einerseits die Informationsspeicherzellen und andererseits die zugehörige Vergleichszelle an die beiden Eingänge des Komparators schalten. Hierzu wird über die zugehörige Wortleitung die gewünschte Zelle der einen Bitleitungshälfte und über die der Adressierung der an die andere Bitleitungshälfte gelegten Vergleichszelle dienende Dummy-Leitung die Vergleichszelle an der jeweils anderen Bitleitungshälfte gleichzeitig adressiert und somit an je einen Eingang des der betreffenden Bitleitung zugeordneten Komparators gelegt. Ist dann die in der angewählten Informationsspeicherzelle vorhandene Ladung grösser als die in der Vergleichszelle anwesende (und beständig aufgefrischte) Ladung, so gibt der insbesondere als Flip-Flop ausgebildete Komparator das Signal logisch «1» und im anderen Fall das Signal logisch «0» ab, das dann in bekannter Weise ausgewertet wird.

Ersichtlich ist somit für die einzelnen Vergleichszellen (oder auch Symmetrierzellen) erforderlich, dass diese einerseits ein kleineres Signal, insbesondere ein halbsogrosses Signal, als die einzelnen Informationsspeicherzellen liefern und dass sie andererseits trotz der hierfür erforderlichen Abänderung gegenüber den eigentlichen Speicherzellen ihre signalbedingten elektrischen Eigenschaften möglichst analog zu den entsprechenden Eigenschaften der eigentlichen Speicherzellen (also der Informationsspeicherzellen) ändern. Um dies zu erreichen hat man bei den aus den genannten Literaturstellen bekannten Speicheranlagen eine der folgenden Möglichkeiten angewendet:

a) Die zwischen den einzelnen Bitleitungen $B_j$ und dem Bezugspotential (Masse) zu legende Signalspannung wird gleich der Versorgungsspannung gewählt und die die Speicherkapazität bestimmende Fläche der einzelnen Vergleichszelle gleich der halben entsprechenden Fläche bei den einzelnen Informationsspeicherzellen eingestellt. Als Nachteil stellt sich bei einem solchen Vorgehen jedoch eine starke Abhängigkeit der Betriebseigenschaften von Strukturänderungen, wie sie z.B. durch Ätztoleranzen bedingt sind, heraus.

b) Man wählt die an die Bitleitungen zu legende Signalspannung etwa gleich der halben Versorgungsspannung und die Fläche der einzelnen Vergleichszellen gleich der Fläche der einzelnen Informationsspeicherzellen, so dass also die Vergleichszellen in der Grösse und Struktur möglichst mit den Informationsspeicherzellen übereinstimmen. Diese Möglichkeit führt jedoch erfahrungsgemäss zu einem undefinierten elektrischen Zustand der Bitleitungen in den Pausen zwischen den einzelnen Abfragezyklen.

Aus «PATENTABSTRACTS OF JAPAN», Band 3, Nr. 124 (E-144), 17. Oktober 1979, Seite 25 E-144 (entsprechend JP-A-54 100 233) ist eine Lösung bekannt, die die Möglichkeit b) benützt:

Zwischen jeweils zwei Bitleitungshälften ist ein Komparator angeordnet, der in üblicher Flip-Flop-Schaltung ausgebildet ist. Den Informationsspeicherzellen jeder Bitleitungshälfte ist eine entsprechende Vergleichszelle an der jeweils anderen Bitleitungshälfte zugeordnet. Innerhalb des Komparators sind die beiden Bitleitungshälften über einen als Schalter wirkenden Quertransistor miteinander verbunden. Die Vergleichzelle ist jedoch in unüblicher Art gestaltet: ein Speicherkondensator ist über zwei parallel geschaltete, von verschiedenen Signalen angesteuerte Transistoren mit der jeweiligen Bitleitungshälfte verbunden. Der eine der beiden Transistoren wird zum Laden des Speicherkondensators verwendet, der andere beim Auslesen von Informationen aus einer der Vergleichszelle zugeordneten Informationsspeicherzelle. Vor dem Auslesen von Information aus einer Informationsspeicherzelle, die der Vergleichszelle zugeordnet ist, sind die beiden Bitleitungshälften aufgrund eines vorausgegangenen Lese- und Bewertezyklus gegenteilig aufgeladen (in etwa auf Versorgungs- bzw. Bezugspotential). Durch geeignetes Ansteuern des Quertransistors im Komparator werden die beiden Bitleitungshälften miteinander kurzgeschlossen: die Ladungen gleichen sich aus und es stellt sich auf beiden Bitleitungshälften ein Ausgleichspotential ein, das in etwa der Hälfte des Versorgungspotentiales entspricht. Dieses Ausgleichspotential wird dann über den einen der beiden Transistoren, die den Speicherkondensator der Vergleichszellen mit der zugehörigen Bitleitungshälfte verbinden, auf diesen Speicherkondensator gebracht. Damit enthält jede Vergleichszelle ein Potential das etwa dem halben Versorgungspotential entspricht.

Durch die Erfindung soll nun eine Lösung angegeben werden, die ohne ins Gewicht fallenden Mehraufwand es gestattet, die unter a) und b) angegebenen Nachteile zu vermeiden, ohne hierfür andere Nachteile in Kauf nehmen zu müssen.

Erfindungsgemäss wird diese Aufgabe durch die kennzeichnenden Merkmale des Patentanspruchs 1 gelöst. Vorteilhafte Weiterbildungen sind in Unteransprüchen gekennzeichnet.

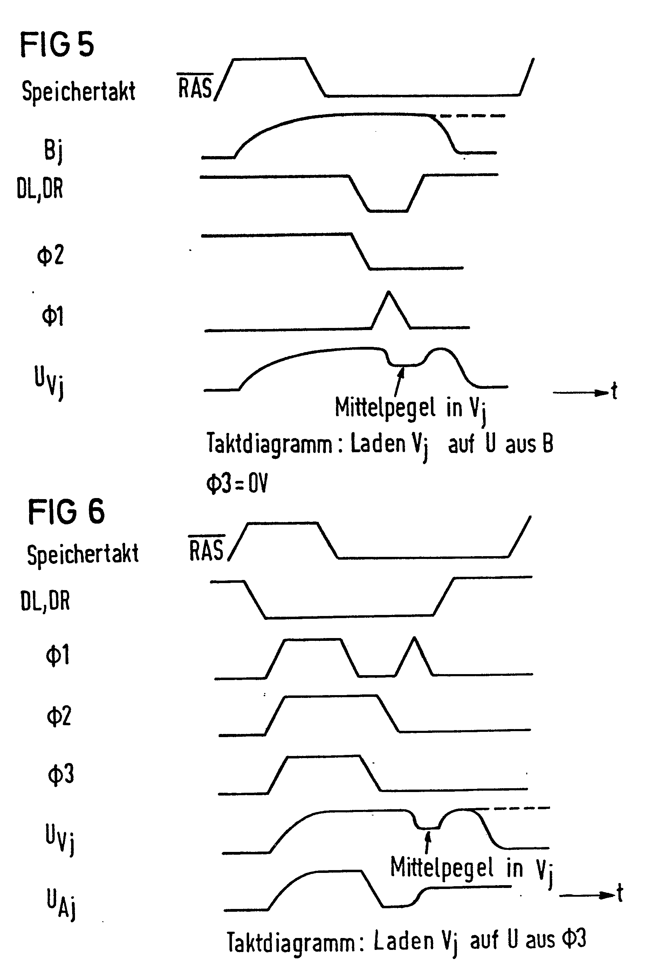

Die Erfindung und deren Vorteile werden nun anhand der Fig. 1 bis 6 näher beschrieben. Dabei ist in Fig. 1 die Kombination zwischen einer der vorgesehenen n Bitleitungen $B_j$ mit dem zugehörigen Komparator $LV_j$ sowie den zugehörigen Vergleichszellen $VL_j$ und $VR_j$ sowie den an die betreffenden Bitleitungen $B_j$ angeschalteten Informationsspeicherzellen $IZL_{ij}$ bzw. $IZR_{ij}$ dargestellt. Die Fig. 2, 3 und 4 zeigen Einzelheiten über die Ausbildung der einzelnen Vergleichszellen nebst der zugehörigen und dem Ladungsausgleich dienenden Ausgleichzelle $AL_j$ bzw. $AR_j$. Fig. 5 und Fig. 6 bringen Einzelheiten über das elektrische Verhalten der in Fig. 2 bis 4 dargestellten Vergleichszelle und deren Taktsteuerung.

Wie gewöhnlich sind auch hier die den einzelnen Matrixspalten j zugeordneten Bitleitungen $B_j$ halbiert, wobei die beiden Hälften $BL_j$ und $BR_j$ gemeinsam adressiert werden. Jede Bitleitungshälfte ist zur Beaufschlagung derselben Anzahl von als Ein-Transistor-Speicherzelle ausgebildeten Informationsspeicherzellen $IZL_{ij}$ bzw. $IZR_{ij}$ in der aus Fig. 1 ersichtlichen Weise vorgesehen, wobei in der Figur im Interesse der Übersichtlichkeit die linke Bitleitungshälfte $BL_j$ sowie die recht Bitleitungshälfte $BR_j$ jeweils lediglich mit einer Informationsspeicherzelle $IZL_{ij}$ bzw. $IZR_{ij}$ versehen, wobei die Zellen $IZL_{ij}$ zur linken Hälfte der Bitleitung $B_j$ und die Zellen $IZR_{ij}$ zur rechten Hälfte der Bitleitung $B_j$ gehören. j ist wiederum die Nummer der betreffenden Bitleitung $B_j$ und läuft von 1 bis n (n = Gesamtzahl der Bitleitungen $B_j$ und damit Spalten der Speichermatrix). Der Index i bezeichnet die Nummer der die betreffende Zelle enthaltenden Zeile und läuft von 1 bis m/2, wobei m die Gesamtzahl der Matrixzeilen ist.

Die einzelne Informationsspeicherzelle $IZL_{ij}$ bzw. $IZR_{ij}$ besteht aus einem MOS-Feldeffekttransistor t vom Anreicherungstyp, dessen Drain mit der zugehörigen Bitleitungshälfte der Bitleitung $B_j$ verbunden ist und dessen Source die Verbindung zu einem die Speicherkapazität der Zelle darstellenden, insbesondere als MOS-Varaktorkapazität ausgebildeten Kondensator C bildet, wobei der andere Pol des Kondensators C an Masse, also am Bezugspotential $V_{ss}$ liegt. Die Adressierung der einzelnen informationstragenden Speicherzellen $IZ_{ij}$ (= $IZL_{ij}$ oder $IZR_{ij}$) erfolgt über die der betreffenden Matrixzeile zugeordnete Wortleitung $W_i$. In der Fig. 1 sind die links der Komparatorreihe angeordneten Wortleitungen mit $WL_i$ und die rechts der Komparatorreihe angeordneten Wortleitungen mit $WR_i$ bezeichnet. Die Adressierung der einzelnen informationstragenden Speicherzellen $IZ_{ij}$ erfolgt ausserdem gleichzeitig mit der Adressierung über die Wortleitung über die der betreffenden Zelle jeweils zugeordnete Bitleitung $B_j$.

Neben den der Informationsspeicherung dienenden Speicherzellen $IZ_{ij}$ hat jede Bitleitungshälfte $BL_j$ bzw. $BR_j$ jeweils noch eine Vergleichszelle $VR_j$ bzw. $VL_j$, die im Aufbau und ihren Eigenschaften den informationstragenden Speicherzellen möglichst gleich sind. Für die Adressierung der den linken Bitleitungshälften $BL_j$ zugeordneten Vergleichszellen $VL_j$ ist eine gemeinsame, den Wortleitungen $WL_i$ entsprechende Adressierleitung DL und für die gemeinsame Adressierung der den rechten Bitleitungshälften $BR_j$ zugeordneten Vergleichszellen $VR_j$ ist ebenfalls eine solche Adressierleitung DR vorgesehen, die den Wortleitungen $WR_i$ entspricht. Die Adressierleitungen DL und DR werden in der Literatur häufig als Dummy-Leitungen (entsprechend dem üblichen Namen Dummy-Zellen für die Vergleichszellen) bezeichnet.

Die betreffende Vergleichszelle $VL_j$ bzw. $VR_j$ wird durch die mit dem Gate ihres Transfer-Transistors verbundene Adressier- oder Dummy-Leitung DL bzw. DR als auch durch die mit dem Drain ihres Transfertransistors verbundene Hälfte $BL_j$ bzw. $BR_j$ der Bitleitung $B_j$ adressiert. Diese Adressierung ist zugleich mit einer Aufladung der Speicherkapazität der betreffenden Vergleichszelle $VL_j$ bzw. $VR_j$ verbunden. Da das die Aufladung der Speicherkapazität in der Vergleichszelle $VL_j$ bzw. $VR_j$ bewirkende Signal mit dem Adressiersignal identisch ist und letzteres dem Zustand «1» der Bitleitung $B_j$ entspricht, gilt dasselbe auch für die Speicherkapazität der adressierten Vergleichszelle $VL_j$ bzw. $VR_j$.

Entsprechend der Erfindung ist nun jeder der Vergleichszellen $VL_j$ bzw. $VR_j$ je eine weitere ihr möglichst gleiche Ein-Transistor-Speicherzelle $AL_i$ bzw. $AR_i$ zugeordnet, die gemeinsam mit der Vergleichszelle adressiert und aufgeladen wird. Allerdings wird für die Aufladung der Speicherkapazität dieser als Ausgleichszelle bezeichneten weiteren Ein-Transistor-Speicherzelle nicht das für die Adressierung der Vergleichszelle $VL_i$ bzw. $VR_i$ verwendete Signal verantwortlich, da die Aufladung der Speicherkapazität der Ausgleichszelle $AL_i$ bzw. $AR_i$ so erfolgen soll, dass der erreichte Ladezustand dem dem Adressiersignal inversen Signal, also dem Zustand logisch «0» entspricht.

Liegt bei angeschaltetem Adressiersignal die Bitleitung $B_i$ gegenüber dem Bezugspotential $V_{ss}$ auf dem Potential U, so dass die Spannung U somit dem Pegel logisch «1» entspricht, so wird man dafür sorgen, dass gleichzeitig mit der Aufladung der Kapazität der Vergleichszelle $VL_i$ bzw. $VR_i$ die Speicherkapazität der zugehörigen Ausgleichszelle $AL_i$ bzw. $AR_i$ entladen wird, so dass mit dem Abschluss der ersten Phase gemäss Definition der Erfindung der Ladezustand der Speicherkapazität der Ausgleichszelle komplementär zum Ladezustand «1» der Speicherkapazität der zugehörigen Vergleichszelle $VL_i$ bzw. $VR_i$ ist und somit den Zustand logisch «0» entspricht.

In der zweiten Phase erfolgt nun der gemäss der Erfindung vorgeschriebene Ladungsausgleich zwischen den Speicherkondensatoren der Vergleichszelle $VL_i$ bzw. $VR_i$ und der zugeordneten Ausgleichszelle $AL_i$ bzw. $AR_i$, was durch Parallelschalten der beiden Speicherkondensatoren erfolgt. Dadurch erhält jeder der Speicherkondensatoren exakt denselben Ladungszustand, so dass die im Speicherkondensator der Vergleichszelle gespeicherte Ladung und die im Speicherkondensator der zugeordneten Ausgleichszelle gespeicherte Ladung jeweils einem genau in der Mitte zwischen den Pegeln logisch «0» und logisch «1» entsprechenden Ladezustand entspricht. Ist, wie in dem angegebenen Beispielsfall, die dem Pegel «1» entsprechende Ladung gleich $Q(1) = Q$ und die dem Pegel logisch «0» entsprechende Ladung gleich $Q(0) = 0$, so hat man nach dem Ladungsausgleich der zweiten Phase für die Ladung beider Speicherkapazitäten den Betrag $Q(0) + (Q(1) - Q(0)):2 = Q/2$.

Vor der dritten Phase wird gemäss der Erfindung die Verbindung zwischen den Speicherkapazitäten der Vergleichszelle $VL_i$ bzw. $VR_i$ und der zugehörigen Ausgleichszelle $AL_i$ bzw. $AR_i$ wieder gelöst, so dass in der nun folgenden dritten Phase für die Steuerung des Komparators $LV_i$ in der Vergleichszelle $VL_i$ bzw. $VR_i$ die angestrebte Steuerspannung U/2 zur Verfügung steht.

Da gewöhnlich die zur Beaufschlagung der Bitleitungen $B_i$ gegenüber Masse verwendete Adressier- und Ladespannung U gleich der zur Versorgung des Leseverstärkers, also des Komparators $LV_i$, vorgesehenen Versorgungsspannung $V_{DD}-V_{ss}$ gewählt ist, wird man zweckmässig die zur Adressierung der Vergleichszellen $VL_i$ bzw. $VR_i$ über die Dummy-Leitungen DL bzw. DR zuzuführenden Adressierimpulse durch Tastung der Versorgungsspannung erzeugen.

Damit ist die der Erfindung zugrunde liegende Aufgabe gelöst.

In Fig. 2 ist das Layout einer Kombination einer Vergleichszelle $V_i$ mit der dazugehörigen Ausgleichszelle $A_i$ dargestellt, während Fig. 3 einen Schnitt durch dieses Layout längs der Linie S–S' und Fig. 4 die dazugehörige Schaltung bringt.

Wie bereits wiederholt festgestellt wurde, bestehen die Vergleichszelle $V_i$ und die zugehörige Ausgleichszelle $A_i$ aus je einer Ein-Transistor-Speicherzelle, die möglichst genau in den Abmessungen und den übrigen Eigenschaften den einzelnen der Informationsspeicherung dienenden Speicherzellen $IS_{ij}$ entsprechen. Demzufolge hat auch die Vergleichszelle $V_i$ und auch die Ausgleichszelle $A_i$ je einen Transfertransistor und je einen Speicherkondensator. Der Transfertransistor der Vergleichszelle ist mit T, der Transfertransistor der Ausgleichszelle mit T2 bezeichnet, während der aus Fig. 4 noch ersichtliche und zwischen den beiden Transistoren T und T2 liegende Verbindungstransistor T1 den in der zweiten Phase beim Betrieb der Vergleichszelle $V_i$ und der Ausgleichszelle $A_i$ vorgesehenen Ladungsausgleich zwischen der Speicherkapazität $CV_i$ der Vergleichszelle $V_i$ und der Speicherkapazität $CA_i$ der Ausgleichszelle $A_i$ ermöglicht.

Demzufolge liegt der Drain des Transfertransistors T der Vergleichszellen $V_i$ an je einer der beiden Hälften der Bitleitung $B_i$, die z.B. als Diffusionszonen in dem den Speicher in monolithisch integrierter Form aufnehmenden und insbesondere aus monokristallinem Silicium bestehenden Substrat vom entgegengesetzten Leitungstyp erzeugt sind. Dabei kann der Drain des Transfertransistors T der Vergleichszelle $V_i$ mit einem Abschnitt der als Diffusionszone ausgebildeten Bitleitungshälfte identisch sein, was im übrigen auch für die Drains der Transfertransistoren t der an die betreffende Bitleitungshälfte ($BL_i$ oder $BR_i$) angeschlossenen Informationsspeicherzellen gilt.

Das Gate des Transfertransistors T der Vergleichszelle $V_i$ kann mit einem Abschnitt der das Gate dieser Vergleichszelle steuernden Adressier- oder Dummy-Leitung D identisch sein, wie dies aus dem Layout gem. Fig. 2 bzw. 3 ersichtlich ist. Die Source des Transfertransistors T der Vergleichszelle $V_i$ liegt einmal an dem ersten Pol der zugehörigen Speicherkapazität $CV_i$, deren zweiter Pol an Masse und damit am Bezugspotential $V_{ss}$ liegt. Andererseits liegt die Source des Transfertransistors T der Vergleichszelle $V_i$ auch am Drain des die Verbindung zu der zugehörigen Ausgleichszelle $A_i$ bildenden Transfertransistors T1.

Die Ausgleichszelle $A_i$ besteht aus der Speicherkapazität $CA_i$ und einem die Aufladung dieser Speicherkapazität bzw. deren Entladung ermöglichenden Transfertransistor T2. Der Drain dieses Transfertransistors T2 ist sowohl mit der Source des Verbindungstransistors T1, als auch mit einem ersten Pol der Speicherkapazität $CA_i$ der Ausgleichszelle $A_i$ verbunden. Eine Verbindung des zweiten Pols der Speicherkapazität $CA_i$ der Ausgleichszelle $A_i$ mit dem zweiten Pol der Spei-

cherkapazität CV$_i$ der zugeordneten Vergleichszelle ist permanent vorgesehen, während die Verbindung zwischen den beiden ersten Polen der
beiden Speicherkapazitäten ausschliesslich über
die Source-Drainstrecke des Verbindungstransistors T1 gegeben ist und nur während der zweiten
Phase im Betrieb der Ausgleichszelle und Vergleichszelle besteht.

Schliesslich sind die nicht an der Source-Drainstrecke des Verbindungstransistors T1 liegenden
zweiten Pole der Speicherkapazität der Ausgleichszelle und der Speicherkapazität der Vergleichszelle mit dem Bezugspotential V$_{ss}$, also
Masse, verbunden. Die Source des Transfertransistors T2 der Ausgleichszelle A$_i$ liegt, wie bereits
festgestellt, an dem ersten Pol der Speicherkapazität CA$_i$ der Ausgleichszelle A$_i$. Sie wird ausserdem in der ersten Betriebsphase während der
Aufladung der Speicherkapazität CV$_i$ der zugeordneten Vergleichszelle V$_i$ durch das über die Bitleitung B$_j$ geführte Adressiersignal mit dem den
zweiten Pol der Speicherkapazität der Ausgleichszelle A$_i$ beaufschlagenden Bezugspotential V$_{ss}$ verbunden und auf diese Weise der angestrebte komplementäre Ladezustand der Speicherkapazität CA$_i$ der Ausgleichszelle A$_i$ zu dem
Ladezustand der Speicherkapazität CV$_i$ der zugeordneten Vergleichszelle V$_i$ in der ersten Arbeitsphase erreicht. Bei der dem Ladungsausgleich
dienenden zweiten Phase, d. h. während der Aktivierung des die Verbindung zwischen den Speicherkapazitäten der Vergleichszelle V$_i$ und der
Ausgleichszelle A$_i$ bildenden Transfertransistors
T1, bleibt jedoch die Verbindung des ersten Pols
der Speicherkapazität CA$_i$ der Ausgleichszelle A$_i$
zum Bezugspotential V$_{ss}$ unterbrochen.

Die Speicherkapazitäten CA$_i$ und CV$_i$ von Vergleichszelle und Ausgleichszelle sind bevorzugt
als MOS-Varaktorkondensatoren ausgebildet.
Demgemäss ist ihr einer Pol durch je eine vom
Substratgebiet durch eine Gateoxydschicht getrennte Leitende Elektrode (vorzugsweise aus dotiertem polykristallinem Silicium) gegeben, während der jeweilige andere Pol durch einen an der
Substratoberfläche unter dem Gateoxyd mittels
der besagten Elektrode induzierten leitenden Kanal gegeben ist.

Zur Steuerung des Gates der Verbindungstransistoren T1 zwischen der Gesamtheit der Vergleichszellen V$_i$ und den ihnen zugeordneten Ausgleichszellen A$_i$ ist ein gemeinsamer Takt $\Phi_1$ vorgesehen, dessen Zeitdiagramm auf Fig. 5 und
Fig. 6 ersichtlich ist. Für die Steuerung des Gates
des Transfertransistors T2 in den Ausgleichszellen A$_i$ ist ebenfalls ein bezüglich seines zeitlichen
Verhaltens in Fig. 5 und Fig. 6 dargestelltes, gemeinsames Taktsignal $\Phi_2$ vorgesehen, während
der Sourceanschluss des Transfertransistors T2
in den vorgesehenen Ausgleichszellen A$_i$ durch
ein Taktsignal $\Phi_3$ beaufschlagt ist. Durch das Zusammenwirken der Taktsignale $\Phi_1$ bis $\Phi_3$ kommt
die oben beschriebene Wirkung zustande.

Ferner ist aus Fig. 5 und Fig. 6 das zeitliche
Verhalten der Taktsignale $\Phi_1$, $\Phi_2$, $\Phi_3$ inbezug auf
die dem eigentlichen Speicherbetrieb des DRAM-Speichers dienenden Betriebstakten zu ersehen,
wobei noch zu bemerken ist, dass die Spannung
U zwischen den Bitleitungen B$_j$ und Masse und
damit zum Substrat im Betriebszustand der einzelnen Bitleitung die Ladespannung für die Speicherkapazitäten in den Vergleichszellen V$_i$ und in
den Informationsspeicherzellen IZ$_{ij}$ bevorzugt
gleich der Versorgungsspannung für die als Komparatoren dienenden Leseverstärker LV$_j$ ist.

Bei den in Fig. 5 und 6 dargestellten Diagrammen ist die Abszisse durch die Zeit t und die
Ordinate durch die Impulsspannung gegeben, die
bevorzugt in allen Fällen gleich der Versorgungsspannung U gewählt ist. Der Betriebsrhythmus
wird dabei durch die Speichertakte $\overline{RAS}$ festgelegt, die periodisch erscheinen und die die der
Informationseingabe bzw. Informationsauslesung
dienenden Prozesse in der bei dynamischen Speichern üblichen Weise steuern.

Massgebend für den Zeitverlauf beim Betrieb
der Vergleichszellen V$_i$ und der Ausgleichszellen
A$_i$ ist einerseits das über eine der Wortleitungen
W$_i$ gegebene Adressiersignal sowie andererseits
das gleichzeitig mit diesem Signal an die die Vergleichszelle V$_i$ steuernde Dummy-Leitung D gegebene Adressiersignal. Der zeitliche Verlauf der
beiden zuletzt genannten Signale ist aus dem
zweiten und dem dritten Diagramm in Fig. 5 gezeigt. Praktisch gleichzeitig mit dem Dummysignal wird das Potential $\Phi_2$ am Gate des Transfertransistors T2 der Ausgleichszellen A$_i$ auf das
Bezugspotential V$_{ss}$ und damit auf den Pegel «0»
abgesenkt. Das am Sourceanschluss dieses
Transfertransistors T2 liegende Potential $\Phi_3$ liegt
dann ebenfalls an V$_{ss}$. Im übrigen ist der Verlauf
der in den verschiedenen Diagrammen von Fig. 5
und 6 gezeigten Spannungen aufgrund der gebrachten Ausführungen über das angestrebte Verhalten der Transistoren T, T1 und T2 (die ebenso
wie die Transfertransistoren t in den Informationsspeicherzellen vom Anreicherungstyp sind)
ohne weiteres verständlich.

**Patentansprüche**

1. Monolithisch integrierter dynamischer Halbleiterspeicher mit wahlfreiem Zugriff (DRAM) mit
einer Matrix aus zeilen- und spaltenweise angeordneten und einander gleichen Informationsspeicherzellen (IZ$_{ij}$) in Gestalt von Eintransistorspeicherzellen, bei dem entweder jeder Matrixspalte
oder jeder Matrixzeile je ein Komparator (LV$_j$) und
zwei ebenfalls durch Eintransistorspeicherzellen
gegebene Vergleichszellen (V$_i$) zugeordnet sind,
wobei jede Eintransistorspeicherzelle eine Speicherkapazität (C, CV$_i$) und einen Transfertransistor (t, T) enthält, wobei die Speicherkapazität
(CV$_i$) jeder Vergleichszelle in etwa gleich ist der
Speicherkapazität (C) jeder Informationsspeicherzelle, dadurch gekennzeichnet, dass jeder der
vorgesehenen Vergleichszellen (V$_i$) je eine zweite
mit der Vergleichszelle (V$_i$) wenigstens bezüglich
der Speicherkapazität (CA$_i$) übereinstimmende
Eintransistorspeicherzelle (A$_i$) als Ladungsausgleichszelle zugeordnet und die Beaufschlagung

dieser Ladungsausgleichszelle ($A_j$) auf die Beaufschlagung der zugehörigen Vergleichszelle ($V_j$) derart abgestimmt ist, dass innerhalb einer ersten Phase eine Aufladung der Speicherkapazität ($CV_j$) der Vergleichszelle ($V_j$) sowie eine Einstellung des Ladezustandes der Speicherkapazität ($CA_j$) der Ladungsausgleichszelle ($A_j$) derart erfolgt, dass der Ladezustand in der Ladungsausgleichszelle ($A_j$) dem zu einem die Aufladung der Vergleichszelle ($V_j$) bewirkenden Signal ($B_j$, $\Phi_3$) komplementären Signal entspricht, dass dann in einer anschliessenden zweiten Phase die beiden Speicherkapazitäten ($CV_j$, $CA_j$) zwecks ladungsausgleich parallel geschaltet und dann bei einer in einer anschliessenden dritten Phase erfolgenden Beaufschlagung des Komparators ($LV_j$) durch die Vergleichszelle ($V_j$) wieder getrennt sind.

2. Halbleiterspeicher nach Anspruch 1, dadurch gekennzeichnet, dass die Informationsspeicherzellen ($IZ_{ij}$), die Vergleichszellen ($V_j$) und die Ladungsausgleichszellen ($A_j$) alle gleichzeitig miteinander hergestellt und alle diese Eintransistorspeicherzellen einander gleich sind.

3. Halbleiterspeicher nach Anspruch 1 oder 2, dadurch gekennzeichnet, dass das der Aufladung der Vergleichszellen ($V_j$) dienende Signal ($B_j$, $\Phi_3$) einen mit der Versorgungsspannung ($V_{DD}$) der als Differenzverstärker ausgebildeten Komparatoren gleichen Hub hat.

4. Halbleiterspeicher nach einem der Ansprüche 1 bis 3, dadurch gekennzeichnet, dass jeweils der eine Pol der Speicherkapazität ($CV_j$) der einzelnen Vergleichszellen ($V_j$) und der Speicherkapazität ($CA_j$) der zugehörigen Ladungsausgleichszelle ($A_j$) fest am Bezugspotential ($V_{ss}$) liegen, während der andere Pol der Speicherkapazität ($CV_j$) der Vergleichszelle ($V_j$) sowohl über den Transfertransistor (T) der Vergleichszelle ($V_j$) mit einer zugehörigen Bitleitung ($B_j$) als auch über einen weiteren Transfertransistor (T1) mit dem anderen Pol der Speicherkapazität ($CA_j$) der zugehörigen Ladungsausgleichszelle ($A_j$) verbunden ist, und dass schliesslich der andere Pol der Speicherkapazität ($CA_j$) der Ladungsausgleichszelle ($A_j$) mit einem der stromführenden Anschlüsse eines Transfertransistors (T2) der Ladungsausgleichszelle ($A_j$) verbunden ist.

5. Halbleiterspeicher nach Anspruch 4, dadurch gekennzeichnet, dass das Gate des Transfertransistors (T2) der Ladungsausgleichszelle ($A_j$) durch einen ersten Taktimpuls ($\Phi_2$) und die andere stromführende Elektrode dieses Transfertransistors (T2) durch einen zweiten Taktimpuls ($\Phi_3$) beaufschlagt sind, dass der erste Taktimpuls ($\Phi_2$) während der ersten Phase den Transfertransistor (T2) der Ladungsausgleichszelle ($A_j$) durchschaltet, dass der zweite Taktimpuls ($\Phi_3$) innerhalb der ersten Phase über den von einem dritten Taktsignal ($\Phi_1$) angesteuerten weiteren Transfertransistor (T1) die Speicherkapazität ($CV_j$) der Vergleichszelle ($V_j$) auf einen Spannungswert ($U_{vj}$) auflädt, der in etwa dem Spannungswert einer aktivierten Bitleitung ($B_j$) entspricht, dass anschliessend, innerhalb dieser ersten Phase, zunächst der dritte Taktimpuls ($\Phi_1$) den weiteren

Transfertransistor (T1) sperrt, so dass die Ladung der Speicherkapazität ($CV_j$) der Vergleichszelle aufgrund des gesperrten Transfertransistors (T) der Vergleichszelle ($V_j$) erhalten bleibt und dann der zweite Taktimpuls ($\Phi_3$) seinen Potentialzustand invertiert, so dass die Speicherkapazität ($CA_j$) der Ladungsausgleichszelle ($A_j$) komplementär zu der Speicherkapazität ($CV_j$) der Vergleichszelle ($V_j$) geladen wird.

## Claims

1. A monolithic integrated dynamic semiconductor store having random access (DRAM), with a matrix consisting of mutually identical information storage cells ($IZi_j$) consisting of one-transistor storage cells arranged in rows and columns, wherein either each matrix column or each matrix row is assigned one comparator ($LV_j$) and two comparator cells ($V_j$) which likewise consist of one-transistor storage cells, where each one-transistor storage cell contains a storage capacitor (C, $CV_j$) and a transfer transistor (t, T), where the storage capacitor ($CV_j$) of each comparator cell is approximately equal to the storage capacitor (C) of each information storage cell, characterised in that each of the provided comparator cells ($V_j$) is assigned a second one-transistor storage cell ($A_j$) identical to the comparator cell ($V_j$) at least in respect of the storage capacitor ($CA_j$), by way of charge compensator cell, and the loading of this charge compensator cell ($A_j$) is matched to the loading of the associated comparator cell ($V_j$) in such manner that within a first phase the storage capacitor ($CV_j$) of the comparator cell ($V_j$) is charged and the charge state of the storage capacitor ($CA_j$) of the charge compensator cell ($A_j$) is set in such manner that the charge state in the charge compensator cell ($A_j$) corresponds to the signal which is complementary to a signal ($B_j$, $\Phi_3$) which causes the comparator cell ($V_j$) to become charged, that then, in a following second phase, the two storage capacitors ($CV_j$, $CA_j$) are connected in parallel for the purpose of charge compensation, and then are separated whereafter, in a following third phase, the comparator ($CV_j$) is acted upon by the comparator cell ($V_j$).

2. A semiconductor store as claimed in Claim 1, characterised in that the information storage cells ($IZ_{ij}$), the comparator cells ($V_j$) and the charge compensator cells ($A_j$) are all produced simultaneously and all these one-transistor storage cells are mutually identical.

3. A semiconductor store as claimed in Claim 1 or Claim 2, characterised in that the signal ($B_j$, $\Phi_3$) which serves to charge the comparator cells ($V_j$) has a range identical to the supply voltage ($V_{DD}$) of the comparators, which are designed as differential amplifiers.

4. A semiconductor store as claimed in one of the Claims 1 to 3, characterised in that the first pole of the storage capacitor ($CV_j$) of the individual comparator cells ($V_j$) and of the storage capacitor ($CA_j$) of the associated charge compensator cell ($A_j$) are permanently connected to the reference

potential ($V_{ss}$), whereas the other pole of the storage capacitor ($CV_j$) of the comparator cell ($V_j$) is on the one hand connected via the transfer transistor (T) of the comparator cell ($V_j$) to an associated bit line ($B_j$), and on the other hand connected via a further transistor (T1) to the other pole of the storage capacitor ($CA_j$) of the associated charge compensator cell ($A_j$), and that finally the other pole of the storage capacitor ($CA_j$) of the charge compensator cell ($A_j$) is connected to one of the current carrying terminals of a transfer transistor (T2) of the charge compensator cell ($A_j$).

5. A semiconductor store as claimed in Claim 4, characterised in that the gate of the transfer transistor (T2) of the charge compensator cell ($A_j$) is acted upon by a first clock pulse ($\Phi_2$) and the other current carrying electrode of this transfer transistor (T2) is acted upon by a second clock pulse ($\Phi_2$), that the first clock pulse ($\Phi_2$) switches through the transfer transistor (T2) of the charge compensator cell ($A_j$) during the first phase, that during the first phase the second clock pulse ($\Phi_3$) charges the storage capacitor ($CV_j$) of the comparator cell ($V_j$) to a voltage value ($U_{vj}$) which corresponds approximately to the voltage value of an activated bit line ($B_j$) via the further transfer transistor (T1) which is driven by a third clock signal ($\Phi_1$), that then, during this first phase, firstly the third clock pulse ($\Phi_1$) blocks the further transfer transistor (T1) so that the charge of the storage capacitor ($CV_j$) of the comparator cell is maintained as a result of the blocked transfer transistor (T) of the comparator cell ($V_j$), and then the second clock pulse ($\Phi_3$) inverts its potential state so that the storage capacitor ($CA_j$) of the charge compensator cell ($A_j$) is charged complementarily to the storage capacitor ($CV_j$) of the comparator cell ($V_j$).

**Revendications**

1. Mémoire monolithique intégrée à semiconducteurs du type dynamique, à accès aléatoire (DRAM), avec une matrice de cellules de mémorisation d'informations ($IZ_{ij}$) identiques entre elles, disposées en lignes et en colonnes et se présentant sous la forme de cellules de mémoire à transistor unique, dans laquelle à chaque colonne de matrice ou à chaque ligne de matrice se trouvent associés un comparateur ($LV_j$) et deux cellules de comparaison ($V_j$) également constituées par des cellules de mémoire à un seul transistor, chaque cellule de mémoire à un seul transistor comportant une capacité de mémorisation ($C,CV_j$) et un transistor de transfert (t, T), et la capacité de mémorisation ($CV_j$) de chaque cellule de comparaison étant sensiblement égale à la capacité de mémorisation (C) de chaque cellule de mémorisation d'informations, caractérisée par le fait qu'à chacune des cellules de comparaison ($V_j$) qui sont prévues et associée, en tant que cellule de compensation des charges, une seconde cellule de mémoire à transistor unique ($A_j$) coïncidant au moins du point de vue de la capacité de mémorisation et que la charge de cette cellule de compensation des charges ($A_j$) est accordée de telle manière avec la charge de la cellule de comparaison associée ($V_j$) que durant une première phase ont lieu une charge de la capacité de mémorisation ($CV_j$) de la cellule de comparaison ($V_j$) de même qu'un réglage de l'état de la charge de la capacité de mémorisation ($CA_j$) de la cellule de compensation des charges ($A_j$) de manière que l'état de la charge de la cellule de compensation des charges ($A_j$) corresponde à un signal complémentaire du signal ($B_j$, $\Phi_3$) qui provoque la charge de la cellule de comparaison ($V_j$), qu'ensuite, et dans une seconde phase qui succède à la première, les deux capacités de mémorisation ($CV_j$, $CA_j$) sont branchées en parallèle pour égaliser les charges, et sont ensuite séparées à nouveau au cours d'une charge du comparateur ($LV_j$) par la cellule de comparaison ($V_j$), qui intervient au cours d'une troisième phase qui fait suite à la seconde.

2. Mémoire à semiconducteurs selon la revendication 1, caractérisée par le fait que les cellules de mémorisation des informations ($IZ_{ij}$), les cellules de comparaison ($V_j$) et les cellules de compensation des charges ($A_j$) sont toutes réalisées simultanément et que toutes ces cellules à transistor unique sont identiques entre elles.

3. Mémoire à semiconducteurs selon la revendication 1 ou 2, caractérisée par le fait que le signal ($V_j$, $\Phi_3$) qui sert à la charge de cellules de comparaison ($V_j$), possède une même excursion que la tension d'alimentation ($V_{DD}$) des comparateurs qui sont réalisés sous la forme d'amplificateurs différenciateurs.

4. Mémoire à semiconducteurs selon l'une des revendications 1 à 3, caractérisée par le fait que respectivement un pôle de la capacité de mémorisation ($CV_j$), les différentes cellules de comparaison ($V_j$) et de la capacité de mémorisation ($CA_j$) de la cellule de comparaison correspondante des charges ($A_j$) est relié à un potentiel de référence ($V_{ss}$), alors que l'autre pôle de la capacité de mémorisation ($CV_j$) de la cellule de comparaison ($V_j$) est relié, tant par l'intermédiaire du transistor de transfert (T) de la cellule de comparaison ($V_j$), au conducteur de bits ($B_j$) associé, qu'avec l'autre pôle de la capacité de mémorisation ($CA_j$) de la cellule de compensation associée des charges ($A_j$), par l'intermédiaire d'un second transistor de transfert (T1), et qu'enfin l'autre pôle de la capacité de mémorisation ($CA_j$) de la cellule de compensation des charges ($A_j$) est relié à l'une des bornes conductrices de courant d'un transistor de transfert (T2) de la cellule de compensation des charges ($A_j$).

5. Mémoire à semiconducteurs selon la revendication 4, caractérisée par le fait que la porte du transistor de transfert (T2) de la cellule de compensation des charges ($A_j$) est chargée par une première impulsion de cadence ($\Phi_2$) et l'autre électrode conductrice de courant de ce transistor de transfert (T2) est chargée par une seconde impulsion de cadence ($\Phi_3$) que la première impulsion de cadence ($\Phi_2$) place, pendant la première phase, le transistor de transfert (T2) de la cellule de compensation des charges ($A_j$) dans son état passant, que la seconde impulsion de cadence ($\Phi_3$) charge, pendant la première phase et par l'intermédiaire du second transistor de transfert (T1) qui est commandé par un troisième signal de cadence ($\Phi_1$), la capacité de mémorisation ($CV_j$) de la cellule de comparaison ($V_j$) à une valeur de tension ($U_{rj}$) qui correspond sensiblement à la valeur de la tension d'un conducteur de bits activé ($B_j$), qu'ensuite, et pendant cette première phase, la troisième impulsion de cadence ($\Phi_1$) bloque

d'abord le second transistor de transfert (T1), en sorte que la charge de la capacité de mémorisation ($CV_j$) de la cellule de comparaison est maintenue en raison de l'état bloqué du transistor de transfert (T) de la cellule de comparaison ($V_j$) et qu'ensuite la seconde impulsion de cadence ($\Phi_3$) inverse son état de potentiel en sorte que la capacité de mémorisation ($CA_j$) de la cellule de compensation des charges ($A_j$) est chargée de façon complémentaire à la capacité de mémorisation ($CV_j$) de la cellule de comparaison ($V_j$).

# FIG 1

# FIG 2

# FIG 3

# FIG 4

0 045 399

# FIG 5

Speichertakt $\overline{RAS}$

Bj

DL,DR

$\phi 2$

$\phi 1$

$U_{Vj}$

Mittelpegel in $V_j$

Taktdiagramm : Laden $V_j$ auf U aus B

$\phi 3 = 0V$

# FIG 6

Speichertakt $\overline{RAS}$

DL,DR

$\phi 1$

$\phi 2$

$\phi 3$

$U_{Vj}$

Mittelpegel in $V_j$

$U_{Aj}$

Taktdiagramm: Laden $V_j$ auf U aus $\phi 3$

11